# FASCICULE DE BREVET EUROPEEN

(11) **EP 1 052 519 B1**
(45) Date de publication et mention de la délivrance du brevet: **01.06.2005**
(21) Numéro de dépôt: 99111241.8
(22) Date de dépôt: 09.06.1999
(51) Int. Cl.: G01R 33/04

(54) **Capteur magnétique réalisé sur un substrat semiconducteur**
Magnetischer F?hler hergestellt auf einem halbleitenden Substrat
Magnetic detector made on a semiconductive substrate

(30) Priorité: 12.05.1999 EP 99109504
(43) Date de publication de la demande: 15.11.2000
(73) Titulaire: Asulab S.A., 2074 Marin (CH)
(72) Inventeur: Chiesi, Laurent, 74160 Saint-Julien en Genevois (FR); Kejik, Pavel, 1024 Ecublens (CH)
(74) Mandataire: Laurent, Jean

(56) Documents cités:
- EP-A- 0 284 196
- DE-A- 3 738 455
- GB-A- 1 179 841
- US-A- 4 267 640
- CHOI S O ET AL: "AN INTEGRATED MICRO FLUXGATE MAGNETIC SENSOR" SENSORS AND ACTUATORS A,CH,ELSEVIER SEQUOIA S.A., LAUSANNE, vol. A55, no. 2/03, 31 juillet 1996 (1996-07-31), pages 121-126, XP000641635 ISSN: 0924-4247

## Description

La présente invention se rapporte à un capteur magnétique substantiellement plan et réalisé notamment sur un circuit intégré, ce capteur magnétique étant de type dit « fluxgate » et étant typiquement destiné à équiper un magnétomètre pour la détection, dans un plan, de champs magnétiques de faible à très faible valeur, par exemple pour applications médicales. Ce magnétomètre est alors réalisé de préférence en technique CMOS, avec son circuit électronique associé intégré au substrat sur lequel est réalisé le capteur.

Comme état de la technique peut être citée la publication « Integrated Planar Fluxgate Sensor With Amorphons Metal Core », de Messieurs L. Chiesi, J. A. Flaganan, B. Janossy, et R. S. Poponic, du Swiss Federal Institute of Technology de Lausanne (SUISSE), présentée lors de la conférence « EuroSensors XI », Varsovie (POLOGNE), 1997.

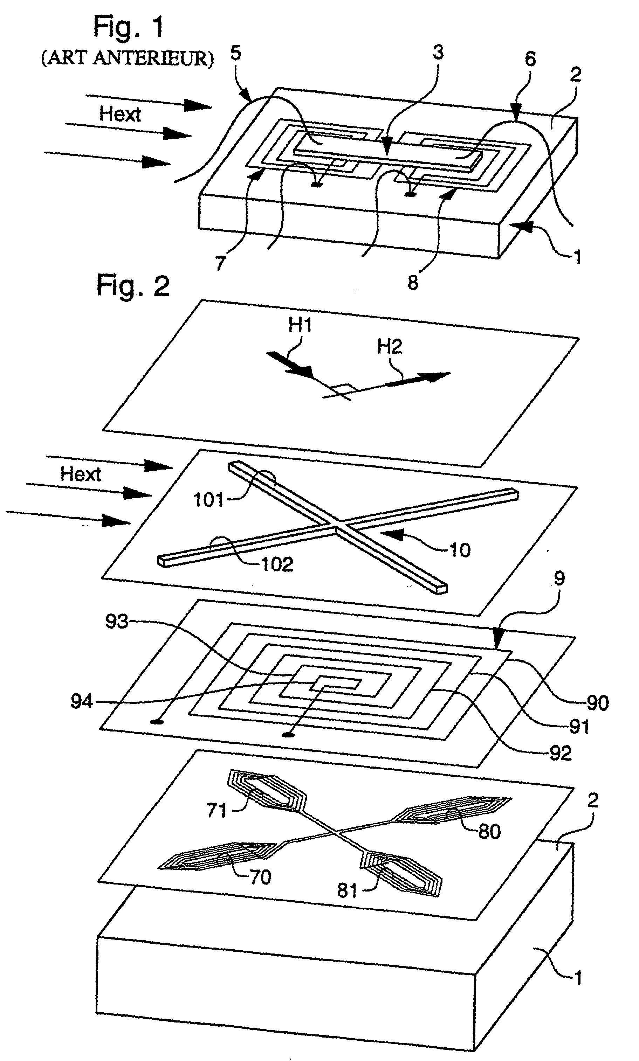

Cette publication décrit un micro-capteur magnétique plan et intégré sur un substrat en Silicium, qui est représenté sur la figure 1 jointe en tant qu'illustration de l'Art Antérieur.

En outre, le document "An integrated micro fluxgate magnetic sensor", de Messieurs S.O. Choi, S. Kawahito, Y. Matsumoto, M. Ishida et Y. Tadokoro du Toyohashi University of Technology (JAPON) publié dans "Sensors and Actuators A-Physical" d'Elsevier, le 1 Mars 1996, décrit un capteur magnétique de type "fluxgate", réalisé sur un substrat semiconducteur, comprenant des films magnétiques, une bobine d'excitation carrée et un circuit de détection constitué par deux bobines planes de détection.

Comme on le voit sur cette figure 1, ce capteur magnétique, ou « fluxgate sensor », est rapporté, par technique d'intégration CMOS, sur un micro-substrat en Silicium 1, ou « silicon chip », constitué par une plaquette de forme parallélépipédique.

Ce micro-capteur est intégré à la grande face supérieure 2 du substrat parallélépipédique 1, ce dernier étant positionné, par rapport au champ magnétique extérieur à mesurer Hext, de manière à ce que cette grande face 2 soit pratiquement coplanaire à ce champ extérieur Hext.

Le capteur magnétique proprement dit comprend un ruban métallique 3 en matériau magnétique amorphe qui est parcouru par un courant d'excitation véhiculé par deux fils d'Aluminium 5, 6 soudés respectivement à chaque extrémité de ce ruban 3. Ce courant d'excitation est un courant alternatif de fréquence f, d'allure triangulaire, qui engendre un champ magnétique, de même fréquence, qui, en raison du caractère non-linéaire de la courbe B-H (flux magnétique-champ magnétique) du ruban ou noyau ferromagnétique amorphe 3, sature périodiquement ce matériau ferromagnétique 3.

Le capteur comporte deux bobines de détection coplanaires 7 et 8, montées en série et en opposition, c'est-à-dire en montage différentiel, qui sont chacune placées respectivement sous une extrémité du ruban ou noyau ferromagnétique amorphe 3, où elles mesurent donc chacune le champ de fuite à ces extrémités respectives.

En raison de la perméabilité non-linéaire du noyau ferromagnétique amorphe 1, la tension détectée par chaque bobine 7 ou 8 contient des harmoniques de la fréquence d'excitation f, dont seuls les harmoniques pairs sont intéressants car ils sont proportionnels au champ magnétique extérieur Hext à mesurer. En général, la détection est donc faite sur la fréquence 2f.

Ce dispositif connu a pour inconvénients d'une part de ne pas permettre, sans avoir à changer la position relative du capteur, d'effectuer la mesure du champ extérieur Hext selon deux directions orthogonales, et d'autre part de manquer de sensibilité. Par ailleurs, sa tension de sortie est dépendante de la fréquence du courant d'excitation et sa consommation en courant est relativement élevée.

L'invention à pour but de proposer un capteur magnétique analogue au capteur selon la figure 1, mais n'en présentant pas les inconvénients précités et grandement amélioré en ce qui concerne ses performances, en particulier sa plus faible consommation en courant ainsi que son aptitude à détecter des champs magnétiques extérieurs Hext de très faible intensité ainsi qu'à détecter des champs magnétiques selon deux directions orthogonales.

Elle se rapporte à cet effet à un capteur magnétique substantiellement plan, réalisé sur un substrat semiconducteur, ce capteur comportant :
- un ou plusieurs noyaux magnétiques qui sont sensiblement plans et rapportés sur une grande face plane de ce substrat,
- au moins un circuit d'excitation, et
- au moins un circuit de détection constitué par au moins deux bobines planes de détection rapportées également sur cette grande face du substrat, caractérisé en ce que ledit circuit d'excitation est formé par une bobine plane unique et de forme extérieure sensiblement carrée, et en ce que ledit ou lesdits noyaux magnétiques sont des noyaux longilignes qui sont disposés, en croix grecque, selon les deux diagonales du carré géométrique défini par le pourtour extérieur de ladite bobine d'excitation plane.

Selon une forme préférentielle de réalisation, ledit noyau magnétique est unique et monobloc, et a une forme de croix grecque disposée selon lesdites diagonales. Avantageusement dans ce cas, le circuit de détection est constitué par quatre bobines de détection qui sont respectivement placées aux quatre extrémités libres dudit noyau magnétique en forme de croix grecque monobloc. De préférence, le matériau formant le ou les noyaux magnétiques est amorphe.

L'invention sera bien comprise, et ses avantages et autres caractéristiques ressortiront, lors de la description suivante de deux exemples non limitatifs de réalisation, en référence au dessin schématique annexé dans lequel :
- la figure 1, déjà décrite précédemment, représente un micro-capteur magnétique de l'Art Antérieur.
- la figure 2 est une vue perspective éclatée et partielle d'une forme préférentielle de réalisation du micro-capteur magnétique de l'invention.
- la figure 3 en est une vue partielle, limitée au noyau magnétique et à sa bobine d'excitation, montrant le sens des champs d'excitation dans chacune des quatre demi-branches de ce noyau magnétique.
- la figure 4 est un diagramme des temps, explicatif du fonctionnement de ce capteur.
- la figure 5 est le schéma électrique synoptique du circuit d'excitation et de détection qui est associé à l'une des deux branches de ce noyau en croix grecque.
- la figure 6 illustre une autre forme de réalisation de ce micro-capteur magnétique.
- la figure 7 illustre l'intérêt de conférer, selon une variante, une forme ellipsoïdale à chacun des barreaux magnétiques amorphes qui équipent en particulier le capteur magnétique de la figure 6.

Sur la figure 2, on a à nouveau désigné par la référence 1 le substrat de forme parallélépipédique, semblable à celui relatif au capteur de l'Art Antérieur précédemment décrit en référence à la figure 1. Ce substrat comporte, réalisé par intégration CMOS sur sa grande surface supérieure 2, le circuit électronique qui est associé au capteur magnétique pour la réalisation complète du magnétomètre, ce circuit électronique intégré n'étant pas représenté sur cette figure.

Ce capteur comporte une bobine d'excitation 9 qui est plane et rapportée sur la face 2 du substrat 2, cette bobine 9 ayant un pourtour externe, constitué par sa spire externe 90, de forme substantiellement carrée. Les autres spires 91 à 94 de cette bobine d'excitation 9 sont concentriques à la spire externe 90, sont elles aussi de forme carrée, et sont comme représenté de dimensions progressivement décroissantes.

Sur cette bobine d'excitation 9 est rapporté, typiquement par collage, un noyau ferromagnétique 10 qui, comme c'est le cas pour le dispositif antérieur selon la figure 1, est constitué par un matériau magnétique amorphe, typiquement réalisé à partir d'un ruban de métal ferromagnétique amorphe disponible dans le commerce.

Cependant, conformément à la présente invention, ce noyau ferromagnétique 10 a une forme de croix grecque, cette forme coïncidant avec les deux diagonales perpendiculaires du carré défini par la spire externe 90 de la bobine d'excitation 9, c'est-à-dire du carré géométrique défini par cette bobine.

On peut ainsi mesurer deux composantes perpendiculaires H1 et H2 du champ magnétique extérieur Hext, ces deux composantes étant respectivement dirigées selon les deux branches orthogonales 101 et 102 du noyau 10. La composante H1 est alors mesurée par la branche 101 du noyau 10, tandis que la composante H2 est mesurée par sa branche orthogonale 102.

La détection est ici effectuée par deux couples coplanaires de bobines de détection, soit
- un premier couple de bobines détectrices 70, 80, planes et rapportées elles aussi par technique CMOS sur la face 2 du substrat 1 et en dessous de la bobine plane d'excitation 9, ces deux bobines détectrices étant montées en série et en arrangement différentiel, et étant respectivement positionnées sous une des deux extrémités libres de la branche 102 du noyau 10. Ce premier couple 70, 80 a donc pour rôle de détecter la composante H2 du champ extérieur Hext.
- un deuxième couple de bobines détectrices 71, 81, identiques aux deux bobines 70, 80, ces deux bobines étant elles aussi montées en série et en arrangement différentiel, et étant respectivement positionnées sous une des deux extrémités libres de l'autre branche 101 du noyau 10. Ce deuxième couple de bobines planes 71, 81, a pour rôle de détecter la composante H1 du champ extérieur Hext.

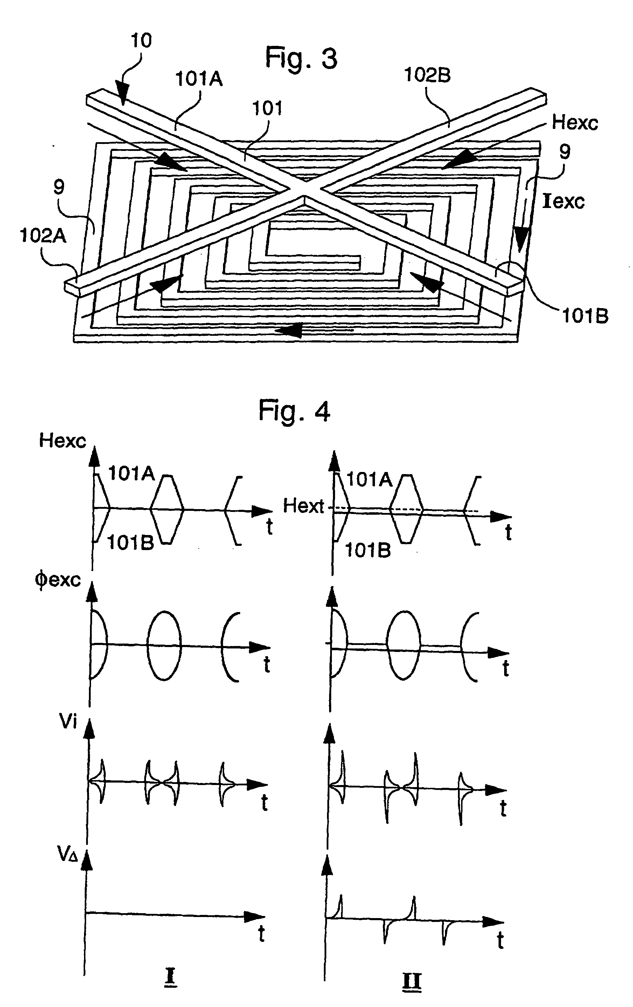

La figure 3 montre la bobine d'excitation 9, avec le sens du courant d'excitation lexc, ce dernier étant d'ailleurs constitué d'impulsions alternativement positives et négatives et avec un rapport cyclique faible, de l'ordre de 1/8 pour fixer les idées, et cette figure montre le sens du champ magnétique d'excitation Hexc produit en conséquence dans chacune des demi-branches 101A, 101B, 102A, 102B du noyau 10.

On voit que, dans chacune des demi-branches 101A, 101B d'une même branche 101 du noyau 10, les champs d'excitation Hexc créés par le courant d'excitation lexc sont de sens contraires.

Il en résulte que, dans chaque branche, 101 ou 102, du noyau 10, le champ magnétique extérieur à mesurer Hext voit une longueur de noyau équivalente à la totalité de la longueur de la branche, alors que le champ d'excitation Hexc ne voit qu'une longueur de noyau équivalente à la moitié de la longueur de cette branche. En conséquence, le champ magnétique extérieur voit un noyau ferromagnétique qui possède une perméabilité apparente équivalente qui est supérieure à celle du champ d'excitation, ce qui finalement augmente grandement la sensibilité du capteur.

La figure 4 permet de comprendre le principe de fonctionnement du capteur, appliqué à l'une des deux branches du noyau 10, c'est-à-dire à la mesure de l'une des deux composantes, H1 ou H2, du champ du magnétique extérieur Hext à mesurer.

La moitié de gauche de cette figure est une première série I de quatre courbes montrant la variation, en fonction du temps t, du champ d'excitation Hexc dans une des branches, 101 par exemple, du noyau, du flux d'excitation φexc correspondant, de la tension induite Vi dans chacune des deux bobines de détection correspondantes, 71 et 81, et de la tension Vs en sortie de l'ensemble de ces deux bobines, cette première série I de courbes étant réalisée en l'absence d'un champ magnétique extérieur Hext à mesurer.

De la même façon, la moitié de droite de cette figure est une seconde série II des quatre mêmes courbes, mais cette fois-ci en présence d'un champ magnétique extérieur à mesurer Hext.

La série de courbes I montre que les champs d'excitation, ainsi que les flux d'excitation φexc et les tensions induites Vi, relatifs aux demi-branches 101 A et 101 B de cette branche 101 du noyau, sont égaux et de signes contraires. La tension de sortie Vs recueillie en sortie du montage série et différentiel des deux bobines de détection 71 et 81 est alors nulle en l'absence de champ extérieur Hext.

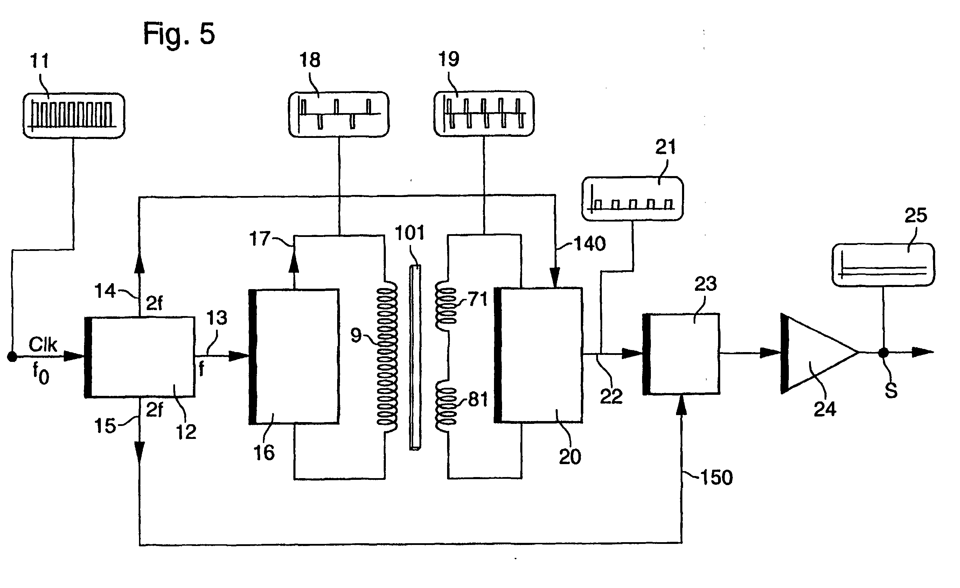

En revanche, la présence d'un champ magnétique extérieur Hext vient, selon la série courbes II, décaler vers le haut la courbe Hexc (t), ce qui entraîne une dissymétrie dans les deux tensions induites Vi, et par suite une sortie Vs non nulle et constituée par une série d'impulsions alternativement positives et négatives. Ces impulsions sont ensuite redressées et lissées pour obtenir une tension de mesure continue, comme on le verra maintenant en référence à la figure 5 qui est un schéma synoptique et fonctionnel du circuit électronique associé à l'une des branches du noyau 10 de ce capteur, par exemple la branche 101.

Comme on le voit sur cette figure 5, on utilise une horloge externe pulsée Clk, d'une fréquence fo fournissant des impulsions 11.

Ces impulsions 11 sont appliquées à un circuit diviseur de fréquence 12 qui délivre plusieurs signaux périodiques alternatifs, à savoir
- deux premiers signaux périodiques déphasés de fréquence f, par exemple égale à 125 kHz sur une première sortie 13;
- deux deuxièmes signaux périodiques déphasés de II, de fréquence 2f, sur une deuxième sortie 14;
- deux troisièmes signaux périodiques déphasés de II, de fréquence 2f, sur une troisième sortie 15.

Les deux premiers signaux sont appliqués à un circuit d'élaboration et mise en forme 16 qui fournit, à sa sortie 17, un courant d'excitation alternatif 18 à rapport cyclique relativement faible, par exemple 1/8, pour l'enroulement d'excitation 9. Le rapport cyclique du courant 18 est déterminé par le déphasage des deux premiers signaux. De préférence, le circuit 16 est agencé de manière que la largeur des impulsions est égale au déphasage temporel de ces deux premiers signaux.

En sortie de l'ensemble des deux bobines de détection 71, 81, on trouve alors un signal induit périodique et pulsé 19, qui est appliqué à un circuit redresseur 20, lui-même commandé à une fréquence 2f par la connexion 140 pour obtenir le signal redressé 21 sur la sortie 22 de ce redresseur 20. On notera que l'on est en présence d'une détection synchrone des harmoniques paires de la fréquence d'excitation f.

Ce signal redressé 21 est alors lissé dans un filtre passe-bas 23, commandé à une fréquence 2f par la connexion 150 de manière à être actif essentiellement pendant la durée des impulsions induites du signal redressé 21. Le signal lissé est ensuite amplifié dans un amplificateur 24 pour finalement obtenir la tension continue de mesure 25 sur la sortie S de ce capteur.

Comme il va de soi, l'invention n'est pas limitée à l'exemple préférentiel de réalisation qui vient d'être décrit.

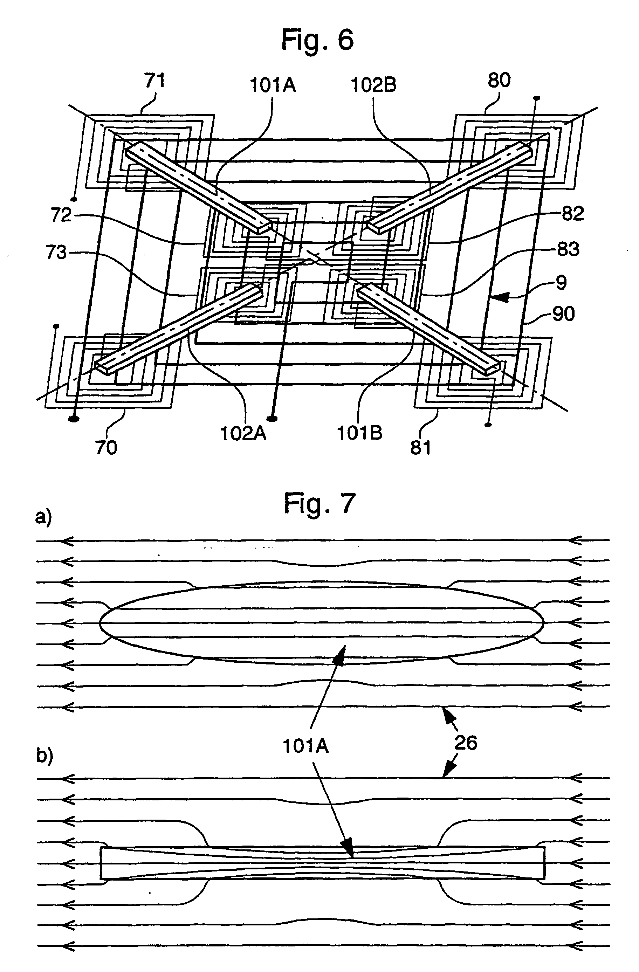

C'est ainsi que, à titre d'exemple, la figure 6 illustre une variante de réalisation de ce capteur, pour laquelle le noyau ferromagnétique amorphe n'est pas comme précédemment constitué en une croix grecque d'un seul tenant, mais est constitué de quatre éléments de noyau en demi-branches 101A, 101B, 102A, 102B rectilignes et distinctes, qui sont disposées comme représenté, et comme dans le cas précédent, selon les deux diagonales du carré que définit la bobine d'excitation 9.

Dans un tel cas, on retrouve les quatre bobines de détection 70, 71, 80, 81 respectivement placées sous les extrémités libres extérieures de ces quatre éléments de noyau 102A, 101A, 102B, 101B, mais on trouve en outre quatre autres bobines de détection 73, 72, 82, 83, qui sont respectivement positionnées sous les extrémités libres intérieures de ces quatre éléments de noyau.

Enfin la figure 7 montre qu'il est éventuellement avantageux, ce qui d'ailleurs est connu en soi, de remplacer chaque élément de noyau rectiligne, par exemple le barreau 101, par un élément d'allure longiligne également, mais de forme ellipsoïdale au lieu de parallélépipédique. Comme le montrent à l'évidence les lignes de force 26 du flux magnétique dans l'un et l'autre cas : on constate une bien plus grande uniformité de ces lignes de force dans le cas du barreau ellipsoïdal.

## Revendications

1. Capteur magnétique substantiellement plan, réalisé sur un substrat semiconducteur (1), ce capteur comprenant :
- au moins un noyau magnétique (10) qui est sensiblement plan et rapporté sur une grande face plane (2) de ce substrat (1),
- au moins un circuit d'excitation (9), et
- au moins un circuit de détection constitué par au moins deux bobines planes de détection (70, 80, 71, 81) rapportées également sur ladite grande face (2) du substrat (1),
**caractérisé en ce que** ledit circuit d'excitation est formé par une bobine plane unique de forme sensiblement carrée (9) et **en ce que** ledit noyau magnétique (10) présente une forme en croix grecque avec deux branches (101, 102; 101A, 101B, 102A, 102B) respectivement selon les deux diagonales de la bobine dudit circuit d'excitation.

2. Capteur magnétique selon la revendication 1, **caractérisé en ce que** ledit noyau magnétique (10) est unique et monobloc.

3. Capteur magnétique selon la revendication 2, **caractérisé en ce que** le circuit de détection est constitué par quatre bobines de détection (70, 80, 71, 81) qui sont respectivement placées aux quatre extrémités extérieures dudit noyau magnétique (10).

4. Capteur magnétique selon l'une des revendications 1 à 3, **caractérisé en ce que** les deux branches (101, 102) sont chacune associées à des bobines de détection (70, 80 ; 71, 81) et à un circuit électronique de mesure (20, 23, 24) relatifs à la mesure de la composante orthogonale (H1 ; H2) du champ magnétique extérieur (Hext) selon la branche considérée.

5. Capteur magnétique selon la revendication 4, **caractérisé en ce que** les bobines de détection (70, 80) associées à une même diagonale (102) sont montées en série et en arrangement différentiel.

6. Capteur magnétique selon la revendication 1, **caractérisé en ce que** chacune des deux branches est formée de deux éléments de noyau distincts.

7. Capteur magnétique selon l'une des revendications précédentes, **caractérisé en ce qu'**il comprend également un circuit électronique de commande(15, 16) qui élabore un courant d'excitation (18) constitué par une série d'impulsions d'excitation alternativement positives et négatives.

8. Capteur magnétique selon la revendication 7, **caractérisé en ce que** ces impulsions d'excitation (18) ont un relativement faible rapport cyclique qui est de l'ordre de 1/8.

9. Capteur magnétique selon la revendication 7 dépendante de la revendication 4, **caractérisé en ce que** ledit circuit électronique de commande (15, 16) et ledit circuit électronique de mesure (20, 23, 24) sont réalisés, en technique d'intégration CMOS, au niveau de ladite grande face (2) du substrat.

10. Capteur magnétique selon l'une des revendications 4 à 9, **caractérisé en ce que** le circuit électronique associé à chacune desdites diagonales comporte au moins :
- un circuit (12) diviseur de la fréquence (fo), des impulsions d'horloge (11) qui sont appliquées à ce circuit,
- un circuit (16) d'élaboration et de mise en forme des impulsions d'excitation (18),
- un circuit redresseur (20) commandé à la fréquence double (2f) de la fréquence d'excitation (f),
- un circuit de lissage et d'amplification (23, 24).

11. Capteur magnétique selon l'une des revendications précédentes, **caractérisé en ce que** ledit noyau magnétique est constitué par un matériau amorphe.

12. Capteur magnétique selon l'une des revendications précédentes, **caractérisé en ce que** les branches (101, 102;101A, 102A, 101B, 102B) dudit noyau ont une forme ellipsoïdale.

## Patentansprüche

1. Magnetischer Sensor, der im Wesentlichen eben ist und auf einem Halbleitersubstrat (1) verwirklicht ist, wobei dieser Sensor umfasst:
- wenigstens einen magnetischen Kern (10), der im Wesentlichen eben ist und an eine ebene Hauptflache (2) dieses Substrats (1) angefügt ist,
- wenigstens eine Erregungsschaltung (9) und
- wenigstens eine Erfassungsschaltung, die aus wenigstens zwei ebenen Erfassungsspulen (70, 80, 71, 81) gebildet ist, die ebenfalls an diese Hauptfläche (2) des Substrats (1) angefügt sind,
**dadurch gekennzeichnet, dass** die Erregungsschaltung aus einer einzigen ebenen Spule gebildet ist, die eine im Wesentlichen quadratische Form (9) besitzt, und dass der magnetische Kern (10) die Form eines griechischen Kreuzes mit zwei Schenkeln (101, 102; 101A, 1018, 102A, 1028) jeweils längs der zwei Diagonalen der Spule der Erregungsschaltung aufweist.

2. Magnetischer Sensor nach Anspruch 1, **dadurch gekennzeichnet, dass** der magnetische Kem (10) einzeln und einteilig vorgesehen ist.

3. Magnetischer Sensor nach Anspruch 2, **dadurch gekennzeichnet, dass** die Erfassungsschaltung durch vier Erfassungsspulen (70, 80, 71, 81) gebildet ist, die jeweils an den vier auf1eren Enden des magnetischen Kerns (10) angeordnet sind.

4. Magnetischer Sensor nach einem der Anspruche 1 bis 3, **dadurch gekennzeichnet, dass** den zwei Schenkeln (101, 102) jeweils Erfassungsschaltungen (70, 80; 71, 81) und eine elektronischen Messschaltung (20, 23, 24) für die Messung der orthogonalen Komponente (H1; H2) des äusseren Magnetfeldes (Hext) längs dem betrachteten Schenkel zugeordnet sind.

5. Magnetischer Sensor nach Anspruch 4, **dadurch gekennzeichnet, dass** die Erfassungsspulen (70, 80), die derselben Diagonalen (102) zugeordnet sind, in Reihe und in differenzieller Schaltung angeordnet sind.

6. Magnetischer Sensor nach Anspruch 1, **dadurch gekennzeichnet, dass** die zwei Schenkel aus zwei verschiedenen Kemelementen gebildet sind.

7. Magnetischer Sensor nach einem der vorhergehenden Ansprüche, **dadurch gekennzeichnet, dass** er ausserdem eine elektronische Steuerschaltung (15, 16) umfasst, die einen Erregungsstrom (18) entwickelt, der durch eine Reihe abwechselnd positiver und negativer Erregungsimpulse gebildet ist.

8. Magnetischer Sensor nach Anspruch 7, **dadurch gekennzeichnet, dass** diese Erregungsimpulse (18) einen verhältnismässig geringen Tastgrad besitzen, der in der Grössenordnung von 1/8 liegt.

9. Magnetischer Sensor nach Anspruch 7 abhängig vom Anspruch 4, **dadurch gekennzeichnet, dass** die elektronische Steuerschaltung (15, 16) und die elektronische Messschaltung (20, 23, 24) in CMOS-Integrationstechnik auf Hohe der Hauptflache (2) des Substrats verwirklicht sind.

10. Magnetischer Sensor nach einem der Anspruche 4 bis 9, **dadurch gekennzeichnet, dass** die elektronische Schaltung, die jeder der Diagonalen zugeordnet ist, wenigstens umfasst :
- eine Teilungsschaltung (12) für die Frequenz (fo) der Taktimpulse (11), die in diese Schaltung eingegeben werden,
- eine Schaltung (16) für die Entwicklung und die Formung der Erregungsimpulse (18),
- eine Gleichrichterschaltung (20), die auf die doppelte Frequenz (2f), der Erregungsfrequenz (f) gesteuert wird,
- eine Glättungs- und Verstärkungsschaltung (23, 24).

11. Magnetischer Sensor nach einem der vorhergehenden Anspruche, **dadurch gekennzeichnet, dass** der magnetische Kern aus einem amorphen Werkstoff gebildet ist.

12. Magnetischer Sensor nach einem der vorhergehenden Anspruche, **dadurch gekennzeichnet, dass** die Schenkel (101,102; 101A, 102A, 1018, 1028) des Kerns ellipsoidförmig sind.

## Claims

1. Substantially planar magnetic sensor, made on a semiconductor substrate (1), this sensor induding:
- at least one magnetic core (10) which is substantially planar and made on a large planar face (2) of said substrate (1 );
- at least one excitation circuit (9); and
- at least one detection circuit formed by at least two planar detection coils (70, 80, 71, 81) also made on said large face (2) of the substrate (1),
**characterised in that** said excitation circuit is formed by a single planar coil (9) of substantially square external shape and **in that** said magnetic core (10) has the shape of a Greek cross with two branches (101, 102; 101A, 101B, 102A, 102B) respectively along the two diagonals of the coil of said excitation circuit.

2. Magnetic sensor according to claim 1, **characterised in that** said magnetic coil (10) is a single monoblock coil.

3. Magnetic sensor according to claim 2, **characterised in that** the detection circuit is formed by four detection coils (70, 80, 71, 81) which are respectively placed at the four outer ends of said magnetic coil.

4. Magnetic sensor according to any of claims 1 to 3, **characterised in that** the two branches (101, 102) are each associated with detection coils (70, 80; 71, 81) and with an electronic measuring circuit (20, 23, 24) related to the measurement of the orthogonal component (H1; H2) of the external magnetic field (Hext) along the respective branch.

5. Magnetic sensor according to claim 4, **characterised in that** the detection coils (70, 80) associated with a same diagonal (102) are mounted in series and in a differential arrangement.

6. Magnetic sensor according to claim 1, **characterised in that** each of the two branches is formed of two distinct core elements.

7. Magnetic sensor according to any of the preceding claims, **characterised in that** it also includes an electronic control circuit (15, 16) which elaborates an excitation current (18) formed by a series of alternately positive and negative pulses.

8. Magnetic sensor according to claim 7, **characterised in that** said excitation pulses (18) have a relatively low duty cycle which is of the order of 1/8.

9. Magnetic sensor according to claim 7 dependent of claim 4 **characterised in** said electronic control circuit (15, 16) and said electronic measuring circuit (20, 23, 24) are made via CMOS integration techniques, on said large face (2) of the substrate.

10. Magnetic sensor according to any of claims 4 to 9, **characterised in that** the electronic circuit associated with each of said diagonals includes at least:
- a circuit (2) for dividing the frequency (f₀) of the clock pulses (11) which are applied thereto;
- an elaboration and shaping circuit (16) for the excitation pulses (18);
- a rectifier circuit (20) controlled at the double frequency (2f) of the excitation frequency (f);
- a smoothing and amplifying circuit (23, 24).

11. Magnetic sensor according to any of the preceding claims, **characterised in that** said magnetic core is formed by an amorphous material.

12. Magnetic sensor according to any of the preceding claims, **characterised in that** the branches (101, 102; 101A, 102A, 101 B, 102B) of said core have an ellipsoidal shape.
